# EUROPEAN PATENT APPLICATION

(11) **EP 4 796 996 A1**
(43) Date of publication of application: **26.08.2026**
(21) Application number: 25158893.5
(22) Date of filing: 19.02.2025
(51) Int. Cl.: G03F 7/00, G03F 9/00

(54) **LITHOGRAPHY SETUP METHOD AND LITHOGRAPHY APPARATUS**

(71) Applicant: ASML Netherlands B.V., 5500 AH Veldhoven (NL)
(72) Inventor: BOUWMAN, Kevin Rutger, 5500 AH Veldhoven (NL); KHO, Sinatra, Canggih, 5500 AH Veldhoven (NL); PEETERS, Johannes, Franciscus, Willebrordus, 5500 AH Veldhoven (NL); ILHAN, Mehmet, Aytunc, 5500 AH Veldhoven (NL)
(74) Representative: ASML Netherlands B.V.

(57) **Abstract**

A method of determining values for a plurality of lithographic apparatus settings for a lithographic apparatus to perform a lithographic process over a plurality of exposure fields on a substrate is described. The method comprises, for each of a plurality of subsets of the plurality of exposure fields: optimizing the values for the plurality of lithographic apparatus settings over a set number of simulation runs, wherein each of the simulation runs after a first simulation run comprises performing a simulation of the lithographic process based on values for the lithographic apparatus settings determined in an immediately preceding simulation run of the number of simulation runs, the first simulation run comprising performing the simulation of the lithographic process based on initial values for the lithographic apparatus settings.

## Description

### FIELD

The present invention relates to lithographic manufacturing methods, and in particular methods of determining settings for a lithographic manufacturing apparatus.

### BACKGROUND

In semiconductor device manufacturing processes, apparatuses can be used to process and/or assess objects such as a semiconductor substrate or a patterning device. An example of such an apparatus is an exposure apparatus used to generate interactions between a radiation, for example an electromagnetic radiation or a charged-particle radiation, with a substrate. Other examples of such apparatuses are a deposition apparatus, an etching apparatus, and a die-bonding apparatus. A lithographic apparatus and an assessment apparatus are examples of an exposure apparatus. A lithographic apparatus may use an electromagnetic radiation or a charged-particle radiation to form a pattern onto a layer of radiation-sensitive material, for example a layer of photo resist, provided on a substrate. Examples of a lithographic apparatus are a deep ultraviolet (DUV) lithographic apparatus and an extreme ultraviolet (EUV) lithographic apparatus. An assessment apparatus may form interaction products resulted from interaction of an electromagnetic radiation or charged-particle radiation with a sample such as a substrate. An inspection apparatus and a metrology apparatus are examples of such assessment apparatuses and may be used to detect particles or measure a critical dimension, for example.

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. For example, by decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

One important parameter of interest to be maintained within specification during a lithographic process is overlay, i.e., the relative positioning of features in one layer with respect to one or more previously exposed layers. However, overlay process corrections may induce fading, which has an impact on the imaging performance in terms of another important parameter of interest: critical dimension (e.g., more specifically global critical dimension uniformity (CDU) and local CDU). Overlay, global CDU and local CDU are contributors to edge placement error (EPE) which describes the error in positioning of a feature or portion thereof.

Simulations of the lithographic performance may be performed to determine one or more lithographic apparatus settings (scanner settings) which e.g., *inter alia* balance overlay performance against imaging performance (fading). These simulations take a long time to complete, e.g., many hours or days.

It is desirable to reduce the simulation time required for determining one or more lithographic apparatus settings.

### SUMMARY

In a first aspect of the invention there is provided a method of determining values for a plurality of lithographic apparatus settings for a lithographic apparatus to perform a lithographic process over a plurality of exposure fields on a substrate, the method comprising, for each of a plurality of subsets of said plurality of exposure fields: optimizing said values for the plurality of lithographic apparatus settings over a set number of simulation runs, wherein, after a first simulation run, each of said simulation runs comprises performing a simulation of said lithographic process based on values for the lithographic apparatus settings determined in an immediately preceding simulation run of said number of simulation runs, said first simulation run comprising performing the simulation of said lithographic process based on initial values for said lithographic apparatus settings.

In a second aspect of the invention there is provided a computer program operable to perform the method of the first aspect, and an associated non-transient computer program carrier. Other aspects of the invention comprise a processing apparatus and lithographic apparatus comprising such a non-transient computer program carrier. In one embodiment, the method of the first aspect of the invention may be a computer implemented method.

The above and other aspects of the invention will be understood from a consideration of the examples described below.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 is a flowchart of a method for determining scanner settings according to an embodiment; and
- Figure 6 illustrates an example method of grouping fields, such as may be employed in a method such as illustrated in Figure 5.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

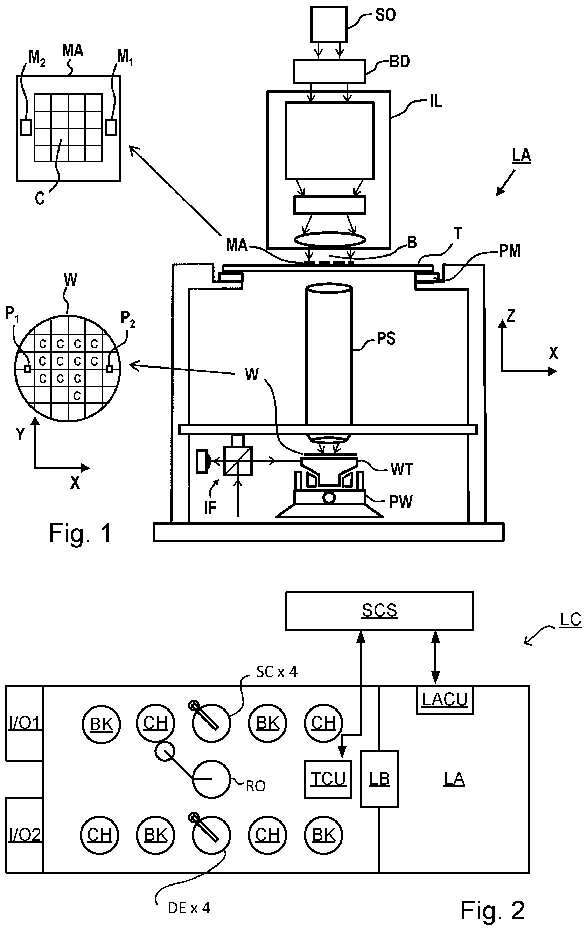

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the angles of incidence of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

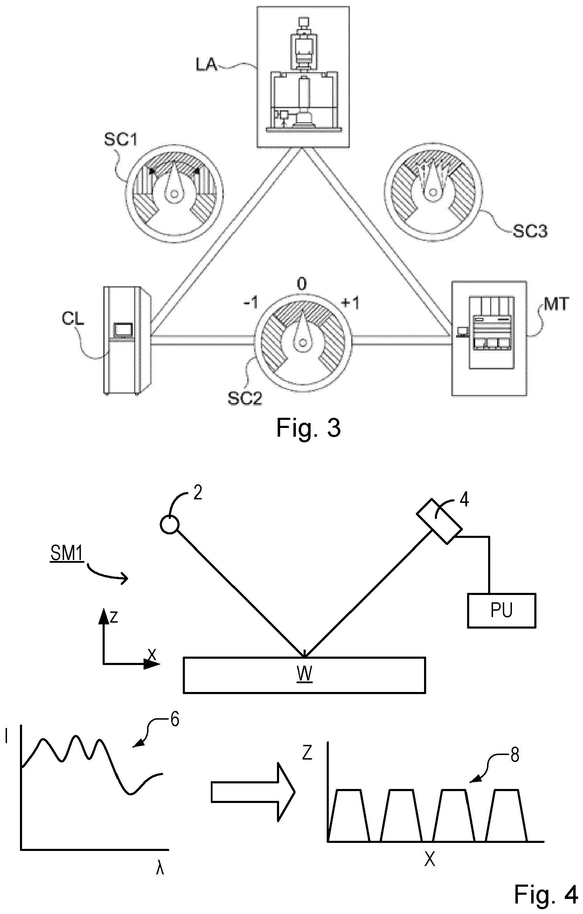

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer. A transmissive version of the example of such a metrology apparatus is also possible. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it also known to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm.

Control of the lithographic process are typically based on measurements fed back or fed forward and then modelled using, for example interfield (across-substrate fingerprint) or intrafield (across-field fingerprint) models. United States Patent Application 20180292761, which is incorporated herein by reference, describes a control method for controlling a performance parameter such as overlay at a sub-field level using an advanced correction model. Another control method using sub-field control is described in European Patent Application EP3343294A1, which is also incorporated herein by reference.

Some of the main contributors to overlay errors include, but are not limited to, the following:
- scanner-specific errors: these may arise from the various subsystems of the scanner used during exposure of the substrate, in effect creating a scanner-specific fingerprint;
- process induced wafer deformation: the various processes performed on the substrates may deform the substrate or wafer;
- illumination setting differences: these are caused by the settings of the illumination system, such as the shape of the aperture, lens actuator positioning, etc.;
- heating effects - heating induced effects will differ between various sub-fields of a substrate, in particular for substrates wherein the various sub-fields include different types of components or structures;
- reticle writing errors: errors may be present already in the patterning device due to limitations in its manufacture; and
- topography variations: substrates may have topography (height) variations, in particular around the edges of wafers.

Modeling overlay error of individual sub-fields of a field (e.g., at die level or other functional area level) can be carried out instead of modeling the overlay error of the field in its entirety, or it can be modeled in addition to modeling the field in its entirety. While the latter requires more processing time, since both the field as well as the sub-fields within it are modeled, it allows for the correction of error sources which relate to a particular sub-field only as well as error sources which relate to the entirety of the field. Other combinations, such as modeling the entire field and only certain sub-fields, are of course possible.

Even where an error is modelled sufficiently, actuation of a resultant correction also presents difficulties. Some corrections simply cannot be actuated effectively using the available control parameters (control knobs). Additionally, while other corrections may be actuatable, actually doing so may result in undesirable side effects. Essentially, due to dynamic and control limitations and sensitivities, there is a limit on what the scanner can actually do to implement a correction.

Typically, scanner overlay control uses dynamic stage position control to adjust placement of structures (features) such that an overlay error is minimized. In principle this may be implemented by pre-correction of an expected overlay error fingerprint (e.g., as induced by a buildup of stress due to application of a subsequent layer) and/or by adjustment of placement of features within the subsequent layer in order to sufficiently align with features in the previous layer(s).

The scanner overlay correction is typically applied by the stage controller and/or lens manipulators of the projection lens (odd aberration control may be used to control placement of features). However, as already mentioned, the scanner cannot perfectly follow any desired overlay correction profile. One reason for this is due to constraints on the speed and acceleration achievable by the wafer (and reticle) stage. Another reason is the fact that the scanner exposes the substrate with a relatively large illumination spot (the so-called slit length being representative for the size of the light spot in the scanning direction, reference: EP application EP19150960.3, which is hereby incorporated by reference in its entirety). The extension of the light spot means that some part of the features within a die / cell will always be sub-optimally positioned during the scanning exposure, in situations where the desired overlay correction is not merely a simple shift across the entire die / cell. This variation of the effective position (overlay) correction during the scanning operation effectively causes a blurring of the aerial image of the features, which in turn leads to a loss of contrast. This dynamic effect is commonly referred to as Moving Standard Deviation (MSD). The limitations on the stage positioning are typically associated with the average position (overlay) error and are commonly referred to as a Moving Average (MA) error.

More specifically, the Moving Average (MA) error and Moving Standard Deviation (MSD) of the error of a lithographic stage relates to a critical time window comprising the time interval that each point on a die is exposed (in other words: receives photons). If the average position error for a point on the die during this time interval is high (in other words: high MA-error), the effect is a shift of the exposed image, resulting in overlay errors. If the standard deviation of the position error during this time interval is high (in other words: high MSD error), the image may smear, resulting in fading errors.

Both average overlay errors (MA) and contrast loss due to MSD are contributors to the overall Edge Placement Error (EPE) budget and hence need to be carefully balanced when determining a certain control profile for a wafer and/or reticle stage; typically a more MA targeted control approach will give a higher MSD impact, while an MSD targeted control strategy may lead to unacceptably large MA errors. EPE is the combined error resultant from global critical dimension uniformity (CDU), local CDU (e.g., line edge roughness LER/ line width roughness LWR) and overlay error. It is these parameters which have the greatest effect on yield, as it is errors in these parameters which effect the relative positioning of features, and whether any two features unintentionally make contact or unintentionally fail to make contact.

As such, while it is desirable to minimize overlay (i.e., overlay error or positional performance parameter), this should be balanced against fading. The introduction of overlay process corrections, e.g., together with internal scanner corrections (such as for example baseline corrections, substrate alignment and/or substrate heating correction) on a scanner induces fading, which in turn has an impact on imaging performance (e.g., an imaging performance parameter).

To address this, the scanner may enable determination of (e.g., tuning) of one or more scanner settings (e.g., via a suitable interface), so as to improve scanner performance, e.g., by ensuring that at least one positional performance parameter and at least one imaging performance parameter are both maintained within specification (at least as much as is possible) and/or errors in at least one positional performance parameter and at least one imaging performance parameter are minimized. For example, the at least one positional performance parameter may comprise a moving average parameter related to a moving average error, such as overlay and the at least one imaging performance parameter may comprise a moving standard deviation parameter related to a moving standard deviation error (e.g., one or more of a fading parameter, critical dimension (CD) parameter and/or focus parameter).

Presently, this tuning may be implemented via performing multiple lithographic process simulations over the setting search space, i.e., a brute force approach which simulates the lithographic process and assesses performance for all combinations of said one or more scanner settings till an optimum or at least acceptable (within specification) performance is found, e.g., in terms of both the at least one positional performance parameter (e.g., overlay) and at least one imaging performance parameter (e.g., fading). This may be done for every layer exposed (e.g., per lot).

Such a method may comprise determining the scanner control parameters (e.g., *inter alia* control trajectories for the stages, lens control parameters) for exposing a substrate which correspond to the scanner settings being assessed, and simulating the lithographic process based on these scanner control parameters to obtain (simulated) lithographic process performance data. This lithographic process performance data may comprise, for example, (simulated) positional performance parameter data (overlay data) and/or (simulated) imaging performance parameter (fading) data. The settings may be determined per exposure field on the substrate such that each field is exposed with respective settings for that field.

The lithographic process performance data for each of the scanner settings can be assessed over the setting search space to find the best scanner settings which optimizes the lithographic process performance. For example, the optimized lithographic process performance may represent the best trade-off between positional performance parameter/overlay performance and imaging performance parameter/fading performance.

This optimization may be done on a per-subset of the exposure fields on the substrate, with the fields grouped beforehand, e.g., based on performance and/or location.

One example of a scanner setting which are determined or optimized in this manner may comprise the "fading factor", i.e., a ratio of MA to MSD. Another scanner setting optimized in this manner may comprise, *inter alia,* one or more optimization parameters used in the scanner optimization for determining the scanner control parameters (e.g., a "RMSMaxAbs" or maximum overlay value which imposes a maximum allowed overlay per field on the optimization cost function). A further scanner setting which may be optimized may comprise an edge clearance value which defines a peripheral substrate region (e.g., an outermost radial region) at the substrate edge, for which the scanner optimization ignores (or weights against). In other words, the scanner optimization may ignore and not optimize performance within this region. The substrate edge is liable to much larger errors compared to the remainder of the substrate, and trying to bring these regions into specification may hinder performance in the other regions, resulting in in an overall worse performance than if the edge region performance is not optimized.

The scanner settings are typically determined for every layer in a layer setup. Presently, the scanner settings may be determined individually for each exposure field of a wafer on each layer (e.g., at least within an edge region defined by the edge clearance value). The brute force approach presently used requires many simulations over a large search space, based on grid search which simulates all combinations of the scanner settings (per exposure field). This is inefficient and takes far too long to be practical in a high-volume manufacturing environment. Presently, a brute force scanner setting determination takes many hours or even days. Therefore, in a high-volume manufacturing environment it is not possible to use current simulation approaches to improve scanner performance without incurring in a throughput penalty. It is desirable to bring this down to tens of minutes; for example, less than an hour or less than half an hour (e.g., about 20 minutes or less).

To achieve this, it is proposed that a determination of the scanner settings may comprise an optimization (e.g., a co-optimization) of the scanner settings, e.g., the fading factor, one or more optimization parameters (e.g., maximum overlay value) and the edge clearance value, over a predetermined and/or fixed number of iterations or simulation runs.

As such, a method of determining values for a plurality of lithographic apparatus settings (i.e., scanner settings) for a lithographic apparatus (i.e., a scanner) to perform a lithographic process over a plurality of exposure fields on a substrate (i.e., a wafer) will be described. The method comprises optimizing the values for the plurality of lithographic apparatus settings over a set number of simulation runs, for each of a plurality of subsets of said plurality of exposure fields. The optimization may comprise a co-optimization of the settings, i.e., optimizing the setting values together. Such a co-optimization may for example use a cost function or optimization function that co-optimizes the lithographic apparatus settings at the same time to find optimized values which, e.g., represent an optimized tradeoff for performance of the lithographic apparatus.

It is proposed that, after a first simulation run, each subsequent simulation run comprises performing a simulation of said lithographic process based on values for the lithographic apparatus settings determined in an immediately preceding simulation run of said number of simulation runs. In other words, the second simulation run will use the optimized settings of the first simulation run, the third simulation run will use the optimized settings of the second simulation run and so on until the final simulation run is performed. The first simulation run comprises performing the simulation of said lithographic process based on initial values for said lithographic apparatus settings.

This can significantly reduce the time taken to determine the scanner settings. For example, an iteration or simulation run may use the result (e.g., intermediate scanner settings) of the previous run (or for the first run, initial or default settings based on an estimate) as a starting point for a further lithographic process simulation, from which the lithographic process performance data for that run is determined and in turn, scanner settings determined which improve the determined lithographic process performance data. The number of runs may be fixed at between 3 and 50, between 5 and 40, between 5 and 30, between 5 and 20, or between 5 and 15 (e.g., 10 in a specific example).

Advangeously, the method of the present invention allows increasing the scanner performance by performing multiple lithographic process simulations and tuning the scanner settings without incurring in any throughput penalty.

The scanner settings are optimized per subset of the exposure fields of the substrate. In particular, the settings may be optimized per field group (i.e., each subset comprises a field group or group of fields comprising one or more fields), with the fields grouped beforehand, e.g., based on performance and/or location. In this way, the scanner settings may be determined to be the same for all of the fields of a group. In this way, the number of separate scanner settings which are optimized may be defined by the number of groups, rather than the number of fields. In the production setting thereafter, each field group can then be exposed with the scanner settings that were optimized for that group.

Alternatively, the optimization may be performed per-field (e.g., with each subset comprising only a single field).

Such an optimization may comprise a co-optimization which may use any suitable co-optimization algorithm. Examples of suitable algorithms include *inter alia:* Gradient descent, Design of Experiment (DoE), Random Search, or Newton's Method. Different algorithms may also be used, e.g., for different groups of fields being optimized.

Alternatively or in addition, the optimization or co-optimization may comprise a suitable machine learning approach, e.g., using a machine learning model, machine learning algorithm and/or framework. By way of a particular example, the optimization may use a reinforcement learning algorithm.

Where convergence on an optimized value is achieved for one or more groups before the maximum number of simulation runs is reached, the remaining simulation runs for these groups can be used to reduce the step size (e.g., fine-tune the determined settings) and provide an improved solution. By contrast, the brute force approach has a fixed step size and can only be interpolated.

The method may comprise an initial grouping or clustering step which groups the fields on the substrate into a plurality of groups or clusters (i.e., such that some or all of the subsets of fields comprise multiple fields which share some similarity according to one or more criteria). Such a step may use any clustering algorithm, or instead may use expect knowledge to group the fields. All of the fields of a group can then be optimized together, e.g., to define the same scanner settings for all of the fields of a group. In this manner, the optimizations performed may be reduced to a per-group optimization rather than a per-field optimization.

Such a grouping or clustering step may be based on simulated data and/or real (measured) data. For example, a simulation may be performed which simulates exposure per field, with the grouping/clustering based on the simulated data. Alternatively or in addition, the grouping/clustering may be performed on measured data related to exposed fields on a wafer (e.g., dose, EPE, overlay, focus etc.). In either case the grouping/clustering may be based on similarity of the simulated and/or measured data.

The grouping may be based on the one or more of the lithographic process performance parameters. Alternatively or in addition, the grouping may be based on location of the field on the substrate. The number of groups may be pre-defined or data-driven (e.g., determined by the clustering algorithm used). Suitable clustering algorithms may include *inter alia* centroid based algorithms (e.g., k-means algorithms), density model algorithms, distribution model algorithms or neural network/artificial intelligence clustering methods. Alternatively to using a clustering algorithm, user expertise may be employed, e.g., based on substrate location and known/common substrate fingerprints.

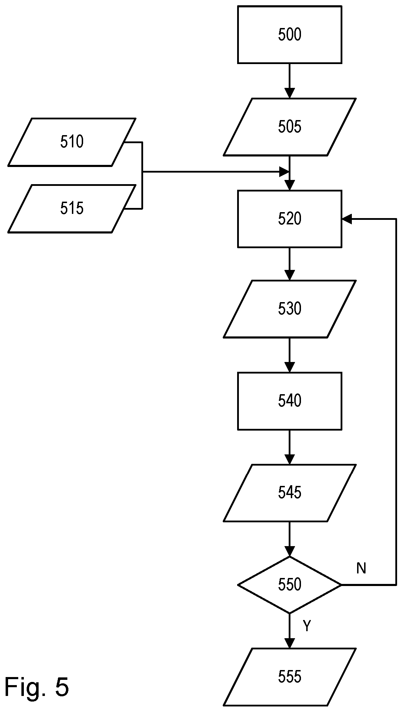

Figure 5 is a flowchart of a method according to a specific example of a method for determining scanner settings such as disclosed herein. At step 500, a grouping or clustering method may be performed which groups the fields of a substrate into a plurality of field groups 505 or subsets having certain common properties or traits (e.g., in terms of overlay and/or fading and/or location on the substrate). As such, the fields within a group will be more similar to each other (e.g., in terms of at least one performance parameter) than to fields within other groups.

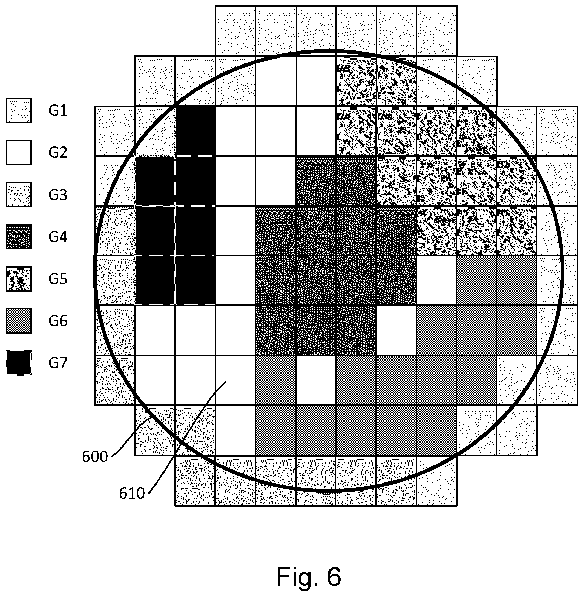

Figure 6 illustrates the result of such a method. A substrate 600 comprises multiple exposure fields 610 (each rectangle, a single field 610 is labeled at random). As a result of a clustering algorithm being applied, each of the 70+ fields 610 of the substrate are grouped into one of 7 groups G1-G7 as distinguished by their shading. The number of field groups here is purely an example, and the number of groups may be more or less than 7, and may be pre-determined or data-dependent.

Referring back to Figure 5, the field groups 505, along with default scanner settings per group 510, and a value for the number of simulation runs that are to be performed 515 are used in a first simulation run. The default scanner settings 510 for each group may be determined based on user expertise, and/or may be set to be the same for all the groups. The number of simulation runs to be performed 515 may be chosen based on time available or allocated for the setting determination for example.

This first simulation run may comprise simulating 520, per field group, scanner control parameter data (e.g., stage trajectories and/or lens corrections) and the resultant scanner performance data 530 which corresponds to default scanner settings 510. As such, this step 520 may comprise simulating a substrate exposure using the default scanner settings 510, thereby determining the control parameters for the scanner during a substrate exposure using the default scanner settings 510, and extracting the resultant overlay and/or fading data (and/or other scanner performance data) 530.

In an optimization step (e.g., co-optimization step) 540, new scanner settings 545 are determined per field group, the new scanner settings 545 being co-optimized to improve the scanner performance. A co-optimization algorithm may be used which analyzes the scanner performance data 530 per field group, e.g., by analyzing the impact of the initial (or previous) scanner settings on positional performance (e.g., overlay residual) and imaging performance (e.g., linear fading, focus and/or CD). The co-optimization may achieve co-optimized positional performance and imaging performance or else may aim to optimize one, while being constrained to achieve at least a minimum performance for the other (e.g., optimizing positional performance/overlay while ensuring imaging performance (e.g., in terms of one or more of fading, focus or CD error.) does not exceed a maximum threshold or *vice versa).* The optimization may comprise an optimization of a suitable cost function which models the effect of the scanner settings on scanner performance (e.g., on overlay and fading, focus and/or CD, or on one of these constrained by the other).

At step 550, it is determined whether the set value for the number of simulation runs 515 has been reached. If not, N, a further simulation run is initiated from step 520, based on the new scanner settings 545 which have just been determined. Optionally, when a field group has converged (i.e., the optimized values for the plurality of lithographic apparatus settings results in simulated performance for its corresponding subset of fields which meets one or more desired specifications) prior to the set value 515 being reached, the co-optimization algorithm can decrease the step size to fine tune the advice (e.g., Adaptive Learning Rate Scheduling), thereby further improving the performance of the lithography apparatus. Alternatively, the settings converged upon can be fixed for the remaining runs. If the set number of simulation runs has been performed Y, then the scanner settings 545 previously determined are output as the final scanner settings per field group 555.

The proposed co-optimization algorithm determines the best scanner settings without the need to search the whole design space. Fewer simulations are required to determine the best scanner settings. By assessing the scanner settings per group, the method will converge faster to the best advice per group. This decreases design space to simulate the impact for each group individually.

Various and further embodiments are as described in the following numbered clauses:
1. A method of determining values for a plurality of lithographic apparatus settings for a lithographic apparatus to perform a lithographic process over a plurality of exposure fields on a substrate, the method comprising, for each of a plurality of subsets of said plurality of exposure fields:
   optimizing said values for the plurality of lithographic apparatus settings over a set number of simulation runs;
   wherein, after a first simulation run, each of said simulation runs comprises performing a simulation of said lithographic process based on values for the lithographic apparatus settings determined in an immediately preceding simulation run of said number of simulation runs, said first simulation run comprising performing the simulation of said lithographic process based on initial values for said lithographic apparatus settings.
2. A method according to clause 1, comprising an initial step of grouping said plurality of exposure fields into said plurality of subsets, such that each of said plurality of subsets comprises one or more exposure fields of said plurality of exposure fields.
3. A method according to clause 2, wherein said grouping is such that the exposure fields within a subset of said plurality of subsets is more similar to each other in terms of one or more properties than to exposure fields in other said subsets of said plurality of subsets.
4. A method according to clause 3, wherein said grouping is performed using a clustering algorithm or method.
5. A method according to clause 3 or 4, wherein said one or more properties comprises one or more of at least one performance parameter and/or location of said exposure field on said substrate.
6. A method according to any preceding clause, wherein each of said simulation runs comprises determining simulated values for at least one performance parameter.
7. A method according to clause 6, wherein determining simulated values for at least one performance parameter comprises simulating the lithographic process using said initial values for the lithographic apparatus settings or said values for the lithographic apparatus settings determined in the immediately preceding simulation run to determine lithographic apparatus control parameters and corresponding said simulated values for at least one performance parameter.
8. A method according to any of clauses 5 to 7, wherein said at least one performance parameter comprises a fading parameter or other imaging performance parameter and/or overlay or other positional performance parameter.
9. A method according to any preceding clause, wherein said plurality of lithographic apparatus settings comprises a fading factor setting.
10. A method according to any preceding clause, wherein said plurality of lithographic apparatus settings comprises one or more optimization parameters for optimizing the lithographic process.
11. A method according to clause 10, wherein said one or more optimization parameters comprises at least one parameter defining a maximum value for at least one performance parameter.
12. A method according to any preceding clause, wherein said plurality of lithographic apparatus settings comprises an edge clearance parameter.
13. A method according to any preceding clause, wherein the number of simulation runs is between 3 and 50.
14. A method according to any preceding clause, wherein the number of simulation runs is between 5 and 20.
15. A method according to any preceding clause, wherein said optimizing comprises using at least one optimization algorithm.
16. A method according to clause 15, wherein said at least one optimization algorithm comprises one or more of a Gradient descent algorithm, a Design of Experiment algorithm, a Random Search algorithm, or a Newton's Method algorithm.
17. A method according to any preceding clause, wherein said optimizing comprises using a machine learning algorithm and/or machine learning model.
18. A method according to clause 17, wherein said machine learning algorithm comprises a reinforcement learning algorithm.
19. A method according to any preceding clause, wherein, if an optimization for at least one subset converges to a solution before the final simulation run of said fixed number of simulation runs, refining the solution for said at least one subset.
20. A method according to clause 19, wherein said refining the solution comprises decrease a step size of the optimization.
21. A method according to any preceding clause, comprising a computer implemented method.
22. A method according to any preceding clause, wherein said optimizing said values for the plurality of lithographic apparatus settings comprises co-optimizing said values for the plurality of lithographic apparatus settings.
23. A method according to any preceding clause, comprising performing said lithographic process on said substrate using said values for a plurality of lithographic apparatus settings.
24. A method according to clause 23, comprising exposing each subset of the plurality of subsets of said plurality of exposure fields respectively with the values for the plurality of lithographic apparatus settings determined for that subset.
25. A computer implemented method according to any of the previous clauses.
26. A computer program comprising program instructions operable to perform the method of any of clauses 1 to 24 when run on a suitable apparatus.
27. A non-transient computer program carrier comprising the computer program of clause 26.
28. A processing apparatus comprising:
   a processor; and
   the non-transient computer program carrier of clause 27.
29. A lithographic apparatus comprising the processing apparatus of clause 28.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a substrate (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. A method of determining values for a plurality of lithographic apparatus settings for a lithographic apparatus to perform a lithographic process over a plurality of exposure fields on a substrate, the method comprising, for each of a plurality of subsets of said plurality of exposure fields:
optimizing said values for the plurality of lithographic apparatus settings over a set number of simulation runs;
wherein, after a first simulation run, each of said simulation runs comprises performing a simulation of said lithographic process based on values for the lithographic apparatus settings determined in an immediately preceding simulation run of said number of simulation runs, said first simulation run comprising performing the simulation of said lithographic process based on initial values for said lithographic apparatus settings.

2. A method as claimed in claim 1, comprising an initial step of grouping said plurality of exposure fields into said plurality of subsets, such that each of said plurality of subsets comprises one or more exposure fields of said plurality of exposure fields.

3. A method as claimed in claim 2, wherein said grouping is such that the exposure fields within a subset of said plurality of subsets is more similar to each other in terms of one or more properties than to exposure fields in other said subsets of said plurality of subsets.

4. A method as claimed in claim 3, wherein said grouping is performed using a clustering algorithm or method.

5. A method as claimed in claim 3 or 4, wherein said one or more properties comprises one or more of at least one performance parameter and/or location of said exposure field on said substrate.

6. A method as claimed in any preceding claim, wherein each of said simulation runs comprises determining simulated values for at least one performance parameter.

7. A method as claimed in claim 6, wherein determining simulated values for at least one performance parameter comprises simulating the lithographic process using said initial values for the lithographic apparatus settings or said values for the lithographic apparatus settings determined in the immediately preceding simulation run to determine lithographic apparatus control parameters and corresponding said simulated values for at least one performance parameter.

8. A method as claimed in any of claims 5 to 7, wherein said at least one performance parameter comprises a fading parameter or other imaging performance parameter and/or overlay or other positional performance parameter.

9. A method as claimed in any preceding claim, wherein said plurality of lithographic apparatus settings comprises one or more of:
a fading factor setting;
one or more optimization parameters for optimizing the lithographic process;
at least one parameter defining a maximum value for at least one performance parameter; and/or an edge clearance parameter.

10. A method as claimed in any preceding claim, wherein the number of simulation runs is between 3 and 50.

11. A method as claimed in any preceding claim, wherein said optimizing comprises using at least one optimization or co-optimization algorithm and/or a machine learning and/or reinforcement learning algorithm.

12. A method as claimed in any preceding claim, wherein, if an optimization for at least one subset converges to a solution before the final simulation run of said fixed number of simulation runs, refining the solution for said at least one subset and/or decreasing a step size of the optimization.

13. A method as claimed in any preceding claim, comprising performing said lithographic process on said substrate using said values for a plurality of lithographic apparatus settings by exposing each subset of the plurality of subsets of said plurality of exposure fields respectively with the values for the plurality of lithographic apparatus settings determined for that subset.

14. A computer program comprising program instructions operable to perform the method of any of claims 1 to 13 when run on a suitable apparatus.

15. A processing apparatus and/or lithographic apparatus comprising:
a processor; and
the non-transient computer program carrier of claim 14.
